# EUROPEAN PATENT APPLICATION

(11) **EP 4 391 745 A1**
(43) Date of publication of application: **26.06.2024**
(21) Application number: 23207522.6
(22) Date of filing: 02.11.2023
(51) Int. Cl.: H05K 7/02, B60R 16/023, H05K 7/14, H05K 7/20

(54) **ELECTRIC DEVICE AND BATTERY PACK SYSTEM**

(30) Priority: 22.12.2022 JP 2022205360
(71) Applicant: Prime Planet Energy & Solutions, Inc., Chuo-ku Tokyo 103-0022 (JP)
(72) Inventor: KAGEYAMA, Takatoshi, Tokyo, 103-0022 (JP); INAMURA, Takashi, Tokyo, 103-0022 (JP)
(74) Representative: Kuhnen & Wacker Patent- und Rechtsanwaltsbüro PartG mbB

(57) **Abstract**

An electric device includes: a housing (120) composed of a metal; an electric component (230, 240) provided to be separated from the housing (120); and a bus bar (290, 290A, 290B) connected to the electric component (230, 240). The bus bar (290, 290A, 290B) includes a first portion (291A, 291B) connected to the electric component (230, 240), and a second portion (292A, 292B) provided at a position close to the housing (120) with respect to the first portion (291A, 291B). A heat transfer portion (200D) having an insulating property and a thermal conductivity higher than a thermal conductivity of air is provided between the second portion (292A, 292B) of the bus bar (290, 290A, 290B) and the housing (120).

## Description

### CROSS REFERENCE TO RELATED APPLICATIONS

This nonprovisional application is based on Japanese Patent Application No. 2022-205360 filed on December 22, 2022 with the Japan Patent Office, the entire contents of which are hereby incorporated by reference.

### BACKGROUND OF THE INVENTION

### Field of the Invention

The present technology relates to an electric device and a battery pack system.

### Description of the Background Art

As a structure for promoting radiation of heat from an electric component in an electric device, a structure described in each of Japanese Utility Model Laying-Open No. H05-008947 and Japanese Patent Laying-Open No. 2000-125448 has been conventionally known, for example.

### SUMMARY OF THE INVENTION

Even when resistance of a conductive portion of an electric component is relatively small in an electric device in which a large amount of current flows, a large amount of heat can be generated in the resistance portion. The conventional heat radiation structure is not necessarily sufficient from the viewpoint of cooling to deal with a large amount of generated heat.

It is an object of the present technology to provide an electric device and a battery pack system so as to attain high efficiency of cooling of an electric component.

The present technology provides the following electric device and battery pack system.
[1] An electric device comprising: a housing composed of a metal; an electric component provided to be separated from the housing; and a bus bar connected to the electric component, wherein the bus bar includes a first portion connected to the electric component, and a second portion provided at a position close to the housing with respect to the first portion, and a heat transfer portion having an insulating property and a thermal conductivity higher than a thermal conductivity of air is provided between the second portion of the bus bar and the housing.
[2] The electric device according to [1], wherein the electric component includes a fuse element or a relay element.
[3] The electric device according to [1] or [2], wherein the heat transfer portion has a thermal conductivity of 1.0 W/m·K or more.
[4] The electric device according to any one of [1] to [3], wherein the heat transfer portion is constituted of a sheet-shaped member.
[5] The electric device according to any one of [1] to [4], wherein the heat transfer portion includes an acrylic-based resin.
[6] The electric device according to any one of [1] to [5], wherein the electric component has a first terminal and a second terminal, the bus bar has a first bus bar connected to the first terminal and a second bus bar connected to the second terminal, and each of the first bus bar and the second bus bar includes the first portion and the second portion.
[7] The electric device according to any one of [1] to [6], wherein the bus bar is constituted of a plate-shaped member, and the first portion and the second portion are formed by performing a bending process onto the plate-shaped member.
[8] The electric device according to any one of [1] to [7], further comprising a cooling plate attached to the housing, wherein the cooling plate has a coolant path.
[9] The electric device according to [8], wherein a clearance is formed between the housing and the cooling plate, a filling material having a thermal conduction property is provided in the clearance, and the heat transfer portion is provided at a position overlapping with the clearance.
[10] A battery pack system comprising: a battery pack including a plurality of battery cells; and the electric device according to any one of [1] to [9], the electric device being electrically connected to the battery pack.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a diagram showing a configuration of a system including a battery pack and an electric pack (electric device).
Fig. 2 is a perspective view showing a battery cell included in the battery pack.
Fig. 3 is a first external view of the electric pack.
Fig. 4 is a second external view of the battery pack.
Fig. 5 is a perspective view showing a configuration of the electric pack.
Fig. 6 is a diagram showing an arrangement inside a case of the electric pack.
Fig. 7 is a diagram showing a mounted structure of a fuse element (electric component).
Fig. 8 is an enlarged cross sectional view showing a modification of a structure around a heat transfer portion.

### DESCRIPTION OF THE PREFERRED EMBODIMENTS

Hereinafter, embodiments of the present technology will be described. It should be noted that the same or corresponding portions are denoted by the same reference characters, and may not be described repeatedly.

It should be noted that in the embodiments described below, when reference is made to number, amount, and the like, the scope of the present technology is not necessarily limited to the number, amount, and the like unless otherwise stated particularly. Further, in the embodiments described below, each component is not necessarily essential to the present technology unless otherwise stated particularly. Further, the present technology is not limited to one that necessarily exhibits all the functions and effects stated in the present embodiment.

It should be noted that in the present specification, the terms "comprise", "include", and "have" are open-end terms. That is, when a certain configuration is included, a configuration other than the foregoing configuration may or may not be included.

Also, in the present specification, when geometric terms and terms representing positional/directional relations are used, for example, when terms such as "parallel", "orthogonal", "obliquely at 45°", "coaxial", and "along" are used, these terms permit manufacturing errors or slight fluctuations. In the present specification, when terms representing relative positional relations such as "upper side" and "lower side" are used, each of these terms is used to indicate a relative positional relation in one state, and the relative positional relation may be reversed or turned at any angle in accordance with an installation direction of each mechanism (for example, the entire mechanism is reversed upside down).

In the present specification, the term "battery" is not limited to a lithium ion battery, and may include other batteries such as a nickel-metal hydride battery and a sodium ion battery.

In the present specification, the term "battery cell" is not necessarily limited to a prismatic battery cell and may include a cell having another shape, such as a cylindrical battery cell, a pouch battery cell, or a blade battery cell. The "battery cell" can be mounted on vehicles such as a hybrid electric vehicle (HEV), a plug-in hybrid electric vehicle (PHEV), and a battery electric vehicle (BEV). It should be noted that the use of the "battery cell" is not limited to the use in a vehicle.

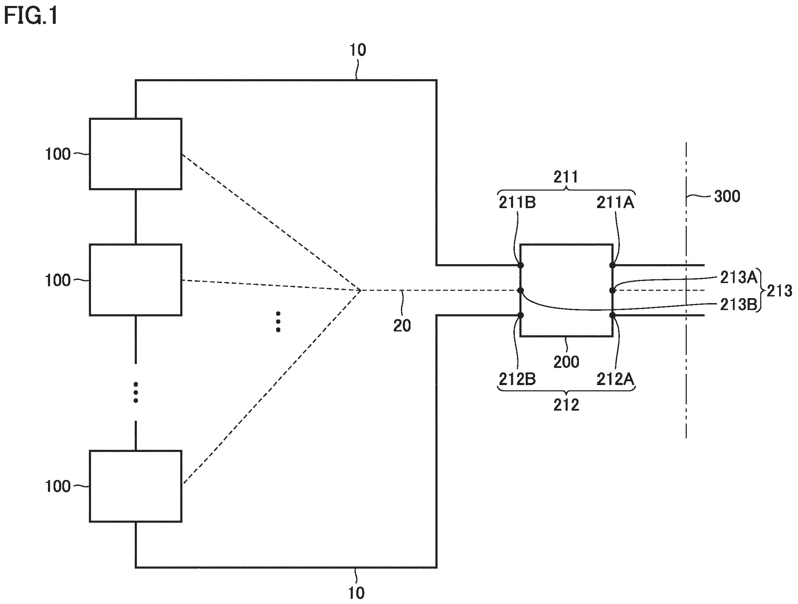

Fig. 1 is a diagram showing a configuration of a battery pack system including battery packs 100 and an electric pack 200 (electric device). As shown in Fig. 1, in the battery pack system, battery packs 100 and electric pack 200 are electrically connected via a charging/discharging line 10 and a signal line 20. The battery pack system can be connected to a vehicle via an interface 300. A current for charging and discharging battery pack 100 flows in charging/discharging line 10. A control signal flows in signal line 20.

In the example of Fig. 1, the plurality of battery packs 100 are electrically connected in series via charging/discharging line 10. In each battery pack 100, a plurality of battery cells are electrically connected in series. Electric pack 200 is electrically connected to each battery pack 100 via signal line 20. Electric pack 200 can control charging and discharging of battery pack 100. The number and manner of connection of battery packs 100 and electric packs 200 can be appropriately changed. Further, electric pack 200 may be provided in battery pack 100.

Electric pack 200 has connectors 211 on the positive electrode side and connectors 212 on the negative electrode side. Of connectors 211, 212, connectors 211A, 211B are each connected to a load on the vehicle side via interface 300, whereas connectors 211B, 212B are each connected to charging/discharging line 10.

Electric pack 200 further has connectors 213. Of connectors 213, a connector 213A is connected to a device on the vehicle side via interface 300, whereas a connector 213B is connected to signal line 20 on the system side.

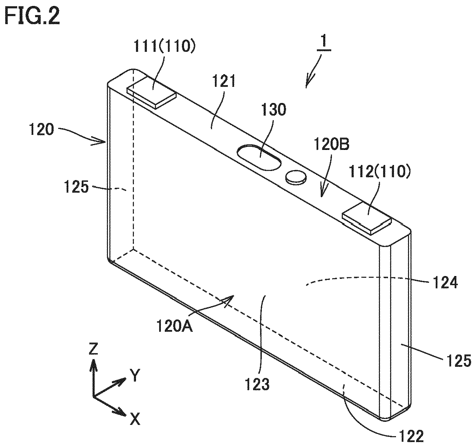

Fig. 2 is a perspective view showing a battery cell 1 included in battery pack 100. As shown in Fig. 2, battery cell 1 has a prismatic shape. However, the shape of the battery cell included in battery pack 100 is not limited to the prismatic shape.

Battery cell 1 illustrated in Fig. 2 has electrode terminals 110, a housing 120, and a gas-discharge valve 130. Electrode terminals 110 are formed on housing 120. Electrode terminals 110 have a positive electrode terminal 111 and a negative electrode terminal 112 arranged side by side along an X axis direction (second direction) orthogonal to a Y axis direction (first direction). Positive electrode terminal 111 and negative electrode terminal 112 are provided to be separated from each other in the X axis direction.

Housing 120 has a rectangular parallelepiped shape and forms an external appearance of battery cell 1. Housing 120 includes: a case body 120A that accommodates an electrode assembly (not shown) and an electrolyte solution (not shown); and a sealing plate 120B that seals an opening of case body 120A. Sealing plate 120B is joined to case body 120A by welding.

Housing 120 has an upper surface 121, a lower surface 122, a first side surface 123, a second side surface 124, and two third side surfaces 125.

Upper surface 121 is a flat surface orthogonal to a Z axis direction (third direction) orthogonal to the Y axis direction and the X axis direction. Electrode terminals 110 are disposed on upper surface 121. Lower surface 122 faces upper surface 121 along the Z axis direction.

Each of first side surface 123 and second side surface 124 is constituted of a flat surface orthogonal to the Y axis direction. Each of first side surface 123 and second side surface 124 has the largest area among the areas of the plurality of side surfaces of housing 120. Each of first side surface 123 and second side surface 124 has a rectangular shape when viewed in the Y axis direction. Each of first side surface 123 and second side surface 124 has a rectangular shape in which the X axis direction corresponds to the long-side direction and the Z axis direction corresponds to the shortside direction when viewed in the Y axis direction.

A plurality of battery cells 1 are stacked such that first side surfaces 123 of battery cells 1, 1 adjacent to each other in the Y direction face each other and second side surfaces 124 of battery cells 1, 1 adjacent to each other in the Y axis direction face each other. Thus, positive electrode terminals 111 and negative electrode terminals 112 are alternately arranged in the Y axis direction in which the plurality of battery cells 1 are stacked.

Gas-discharge valve 130 is provided in upper surface 121. When the temperature of battery cell 1 is increased (thermal runaway) and internal pressure of housing 120 becomes more than or equal to a predetermined value due to gas generated inside housing 120, gas-discharge valve 130 discharges the gas to outside of housing 120.

Each of battery packs 100 shown in Fig. 1 is formed by accommodating a plurality of battery cells 1 in a pack case. Battery pack 100 may be such that the side surface portion of the pack case directly supports the stack of battery cells 1 (Cell-to-Pack structure), or may be such that a battery module including the plurality of battery cells 1 is accommodated in the pack case (Cell-Module-Pack structure).

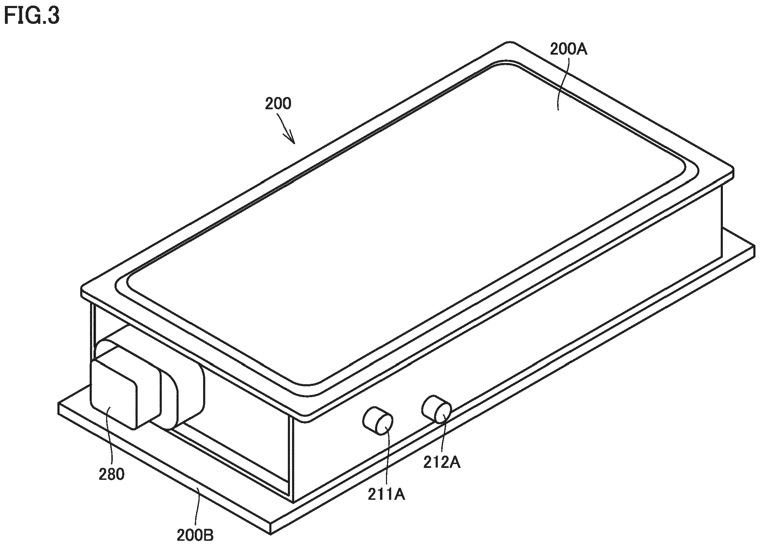

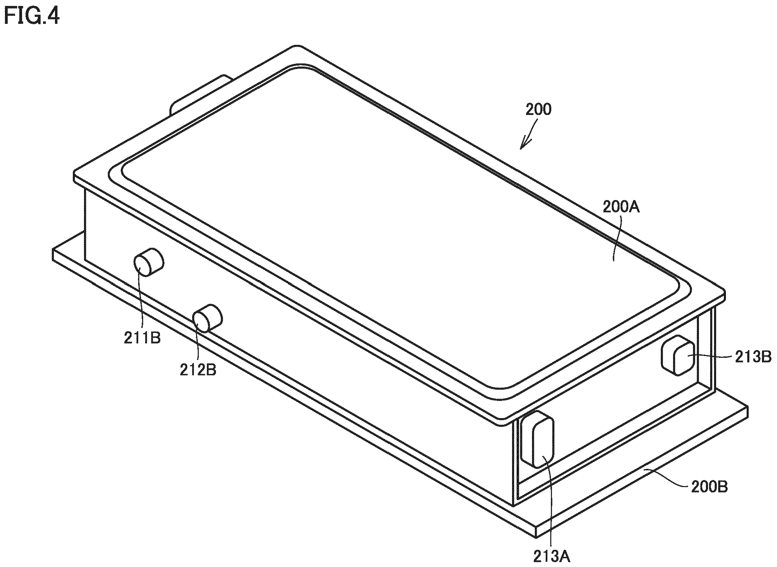

Each of Figs. 3 and 4 is an external view of electric pack 200. As shown in Figs. 3 and 4, electric pack 200 includes a case member 200A and a cooling plate 200B. Cooling plate 200B can constitute a bottom surface of case member 200A. Connectors 211A, 211B, 212A, 212B, 213A, 213B and a service plug 280 are provided on side surfaces of case member 200A. Electric components are accommodated in an inner space of case member 200A.

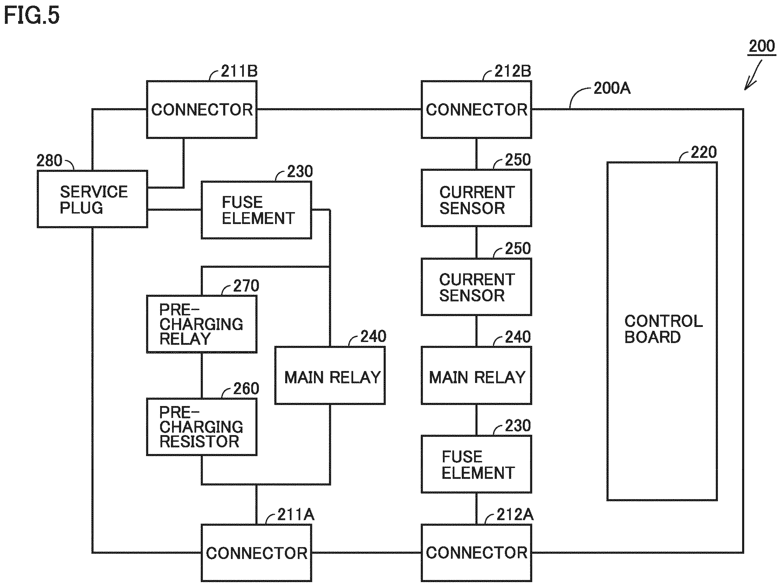

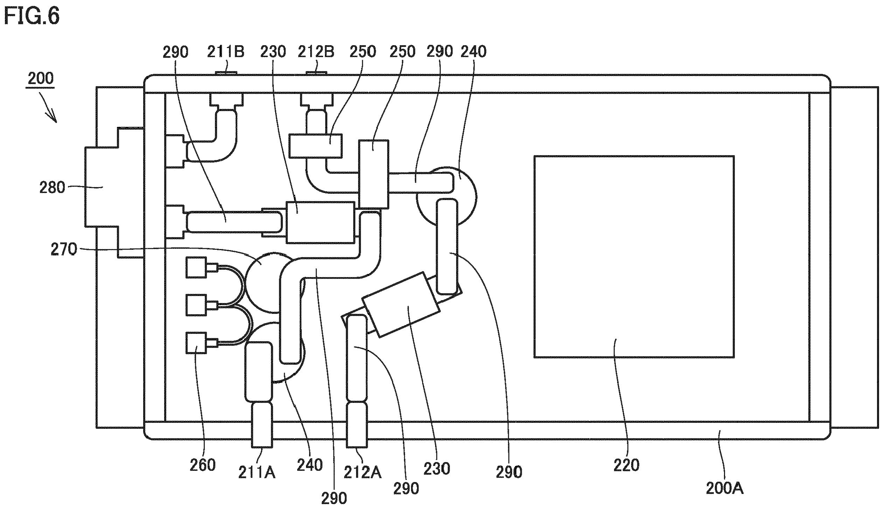

Fig. 5 is a perspective view showing an configuration of electric pack 200, and Fig. 6 is a diagram showing an arrangement inside case member 200A of electric pack 200. As shown in Figs. 5 and 6, electric pack 200 includes a control board 220, fuse elements 230, main relays 240, current sensors 250, a pre-charging resistor 260, and a pre-charging relay 270.

Fuse elements 230, main relays 240, current sensors 250, pre-charging resistor 260, and pre-charging relay 270 are electric components accommodated in the inner space of case member 200A, and are connected to the outside of electric pack 200 via connectors 211A, 211B, 212A, 212B. Control board 220 is also an electric component accommodated in the inner space of case member 200A, and is connected to the outside of electric pack 200 via connectors 213A, 213B. Other electric components not shown in Figs. 5 and 6 may be accommodated in case member 200A.

As shown in Fig. 6, fuse elements 230 are electrically connected to connector 212A, main relays 240, pre-charging relay 270, and service plug 280 via bus bars 290.

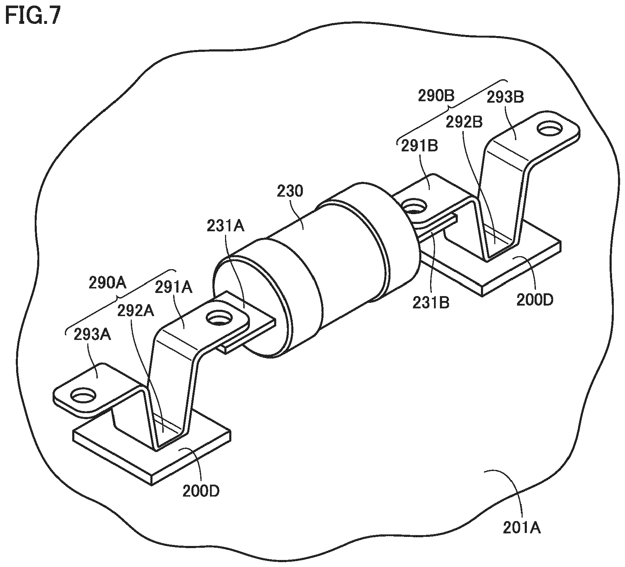

Fig. 7 is a diagram showing a mounted structure of fuse element 230 (electric component). As shown in Fig. 7, fuse element 230 is provided to be separated from housing 201A composed of a metal and constituting a portion of case member 200A. It should be noted that the mounted structure of fuse element 230 will be illustratively described below; however, the electric component according to the present technology is not limited to fuse element 230, and the same mounted structure can be also applied to other electric components such as main relay 240 (relay element), for example.

Fuse element 230 has a terminal 231A (first terminal) and a terminal 231B (second terminal). A bus bar 290A (first bus bar) is connected to terminal 231A, and a bus bar 290B (second bus bar) is connected to terminal 231B.

Bus bars 290A, 290B respectively include: first portions 291A, 291B each connected to fuse element 230; second portions 292A, 292B provided at positions close to housing 201A with respect to first portions 291A, 291B; and third portions 293A, 293B provided at positions away from housing 201A with respect to second portions 292A, 292B. The heights (separation heights) of first portions 291A, 291B from housing 201A may be substantially the same as or different from the heights (separation heights) of third portions 293A, 293B from housing 201A.

Each of first portions 291A, 291B, second portions 292A, 292B, and third portions 293A, 293B of bus bars 290A, 290B can be formed by performing a bending process onto a plate-shaped member composed of a metal. It should be noted that a bus bar constituted only of first portions 291A, 291B and second portions 292A, 292B may be formed without forming third portions 293A, 293B.

Between each of second portions 292A, 292B of bus bars 290A, 290B and housing 201A, a heat transfer member 200D (heat transfer portion) having an insulating property and a thermal conductivity higher than that of air is provided. Heat transfer member 200D is preferably composed of a material having thermal conductivity and dielectric strength each having a value equal to or more than a certain value.

For example, heat transfer member 200D preferably has a thermal conductivity of about 1.0 W/m·K or more. As an example, heat transfer member 200D is constituted of a sheet-shaped member having elasticity and including an acrylic-based resin (thermally conductive acrylic-based heat-radiation material). More specifically, heat transfer member 200D may be formed using 6500H provided by 3M Company.

It should be noted that the configuration of heat transfer member 200D is not limited to the one described above, and heat transfer member 200D may be composed of a gel-like material, for example.

With an increase in size of battery pack 100 or the battery module, a large amount of current is likely to flow in electric pack 200 connected to battery pack 100. Even when resistance of a conductive portion of the electric component such as fuse element 230 is relatively small in electric pack 200 in which a large amount of current flows, a large amount of heat can be generated in the resistance portion.

To address this, in electric pack 200 according to the present embodiment, heat generated in fuse element 230 is transferred from fuse element 230 to housing 201A composed of a metal via bus bars 290A, 290B and heat transfer members 200D, thereby efficiently radiating the heat. As a result, the electric component such as fuse element 230 can be efficiently cooled. Further, since the above-described mounted structure can be obtained only by processing bus bars 290A, 290B and installing heat transfer member 200D, the structure of electric pack 200 is suppressed from being complicated.

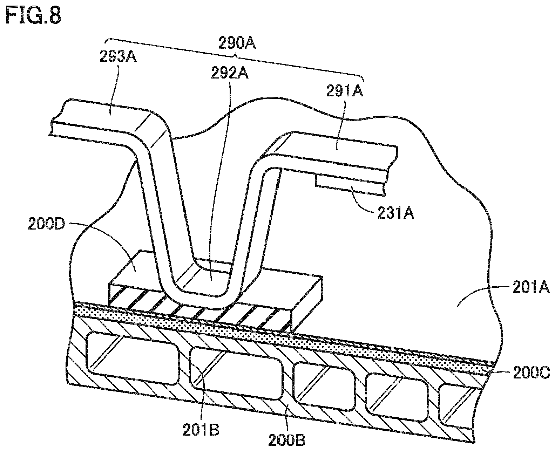

Fig. 8 is an enlarged cross sectional view showing a modification of the structure around heat transfer member 200D. In the example shown in Fig. 8, cooling plate 200B having a coolant path 201B and housing 201A overlap with each other. A gap filler 200C (filling material) having a thermal conduction property is provided in a clearance formed between housing 201A and cooling plate 200B. Heat transfer member 200D is provided at a position overlapping with the clearance in which gap filler 200C is provided.

Gap filler 200C may be in the form of a paste or may be in the form of a sheet obtained by curing the paste. Gap filler 200C preferably has a thermal conductivity comparable to or higher than that of heat transfer member 200D.

In the example shown in Fig. 8, the heat generated in fuse element 230 is transferred from fuse element 230 to housing 201A via bus bar 290A and heat transfer member 200D, and is further transferred to cooling plate 200B having coolant path 201B via gap filler 200C. As a result, efficiency of cooling of fuse element 230 can be further improved.

Although the embodiments of the present invention have been described and illustrated in detail, it is clearly understood that the same is by way of illustration and example only and is not to be taken by way of limitation. The scope of the present invention is defined by the terms of the claims, and is intended to include any modifications within the scope and meaning equivalent to the terms of the claims.

## Claims

1. An electric device comprising:
a housing (120) composed of a metal;
an electric component (230, 240) provided to be separated from the housing (120); and
a bus bar (290, 290A, 290B) connected to the electric component (230, 240), wherein
the bus bar (290, 290A, 290B) includes a first portion (291A, 291B) connected to the electric component (230, 240), and a second portion (292A, 292B) provided at a position close to the housing (120) with respect to the first portion (291A, 291B), and
a heat transfer portion (200D) having an insulating property and a thermal conductivity higher than a thermal conductivity of air is provided between the second portion (292A, 292B) of the bus bar (290, 290A, 290B) and the housing (120).

2. The electric device according to claim 1, wherein the electric component (230, 240) includes a fuse element (230) or a relay element (240).

3. The electric device according to claim 1 or 2, wherein the heat transfer portion (200D) has a thermal conductivity of 1.0 W/m K or more.

4. The electric device according to any one of claims 1 to 3, wherein the heat transfer portion (200D) is constituted of a sheet-shaped member.

5. The electric device according to any one of claims 1 to 4, wherein the heat transfer portion (200D) includes an acrylic-based resin.

6. The electric device according to any one of claims 1 to 5, wherein
the electric component (230) has a first terminal (231A) and a second terminal (231B),
the bus bar (290, 290A, 290B) has a first bus bar (290A) connected to the first terminal (231A) and a second bus bar (290B) connected to the second terminal (231B), and
each of the first bus bar (290A) and the second bus bar (290B) includes the first portion (291A, 291B) and the second portion (292A, 292B).

7. The electric device according to any one of claims 1 to 6, wherein
the bus bar (290, 290A, 290B) is constituted of a plate-shaped member, and
the first portion (291A, 291B) and the second portion (292A, 292B) are formed by performing a bending process onto the plate-shaped member.

8. The electric device according to any one of claims 1 to 7, further comprising a cooling plate (200B) attached to the housing (120), wherein
the cooling plate (200B) has a coolant path (201B).

9. The electric device according to claim 8, wherein
a clearance is formed between the housing (120) and the cooling plate (200B),
a filling material (200C) having a thermal conduction property is provided in the clearance, and
the heat transfer portion (200D) is provided at a position overlapping with the clearance.

10. A battery pack system comprising:
a battery pack (100) including a plurality of battery cells (1); and
the electric device according to any one of claims 1 to 9, the electric device being electrically connected to the battery pack (100).
